# EUROPEAN PATENT APPLICATION

(11) **EP 4 040 468 A1**
(43) Date of publication of application: **10.08.2022**
(21) Application number: 20872323.9
(22) Date of filing: 28.09.2020
(51) Int. Cl.: H01L 21/02, H01L 29/06, H01L 29/41, H01L 29/47, H01L 29/872, H01L 21/329

(54) **METHOD FOR MANUFACTURING SEMICONDUCTOR ELEMENT, AND SEMICONDUCTOR DEVICE**

(30) Priority: 30.09.2019 JP 2019178961
(71) Applicant: Kyocera Corporation, Kyoto-shi Kyoto 612-8501 (JP)
(72) Inventor: AZUMA, Katsunori, Kyoto-shi, Kyoto 612-8501 (JP); KOMATSU, Naoyoshi, Kyoto-shi, Kyoto 612-8501 (JP); SAWADA, Tatsuro, Kyoto-shi, Kyoto 612-8501 (JP); NAKAZATO, Yusuke, Kyoto-shi, Kyoto 612-8501 (JP); HIRAYAMA, Tomohisa, Kyoto-shi, Kyoto 612-8501 (JP)
(74) Representative: Viering, Jentschura & Partner mbB Patent- und Rechtsanwälte
(86) International application number: PCT/JP2020/036647
(87) International publication number: WO 2021/065803

(57) **Abstract**

A method for manufacturing a semiconductor element includes providing, on a surface of a substrate 11, a mask 12 which has an opening 12a and in which a peripheral upper surface region of the opening is processed to have a predetermined structure, and epitaxially growing a semiconductor from the surface of the substrate exposed from the opening to the top of the peripheral upper surface region to fabricate a semiconductor element having a semiconductor layer 13 with the predetermined structure transferred thereon. In one example, the predetermined structure is due to a shape having a difference in level. In another example, the predetermined structure is due to a selectively arranged element, and the transferred element moves into the semiconductor layer.

## Description

### Technical Field

The present disclosure relates to a method for manufacturing a semiconductor element, and a semiconductor device.

### Background Art

There is a known technique called ELO (epitaxial lateral overgrowth) in which a GaN (gallium nitride) layer is formed by crystal growth in an opening of a growth mask provided on a substrate, and the crystals are further grown on the growth mask in the lateral direction (Japanese Patent No. 4638958).

### Summary of Invention

A method for manufacturing a semiconductor element according to one aspect of the present disclosure includes providing, on a surface of a substrate, a mask which has an opening and in which a peripheral upper surface region of the opening is processed to have a predetermined structure, and epitaxially growing a semiconductor from the surface of the substrate exposed from the opening to the top of the peripheral upper surface region to fabricate a semiconductor element having a semiconductor layer with the predetermined structure transferred thereon.

### Brief Description of Drawings

[Fig. 1A] Fig. 1A is a schematic sectional view for describing a first embodiment of the present disclosure.
[Fig. 1B] Fig. 1B is a schematic sectional view for describing the first embodiment of the present disclosure.
[Fig. 1C] Fig. 1C is a schematic sectional view for describing the first embodiment of the present disclosure.
[Fig. 1D] Fig. 1D is a schematic sectional view for describing the first embodiment of the present disclosure.
[Fig. 1E] Fig. 1E is a schematic sectional view for describing the first embodiment of the present disclosure.
[Fig. 2] Fig. 2 is a schematic sectional view for describing the first embodiment of the present disclosure.
[Fig. 3] Fig. 3 is a schematic perspective view for describing the first embodiment of the present disclosure.
[Fig. 4A] Fig. 4A is a schematic sectional view for describing a second embodiment of the present disclosure.
[Fig. 4B] Fig. 4B is a schematic sectional view for describing the second embodiment of the present disclosure.
[Fig. 4C] Fig. 4C is a schematic sectional view for describing the second embodiment of the present disclosure.
[Fig. 5A] Fig. 5A is a schematic sectional view for describing a third embodiment of the present disclosure.
[Fig. 5B] Fig. 5B is a schematic sectional view for describing the third embodiment of the present disclosure.
[Fig. 5C] Fig. 5C is a schematic sectional view for describing the third embodiment of the present disclosure. Description of Embodiments

An embodiment of the present disclosure will be described below with reference to the drawings.

### [First Embodiment]

First, a method for manufacturing a semiconductor element, and a semiconductor device of a first embodiment will be described.

### (Manufacturing method)

A semiconductor element is manufactured as follows.

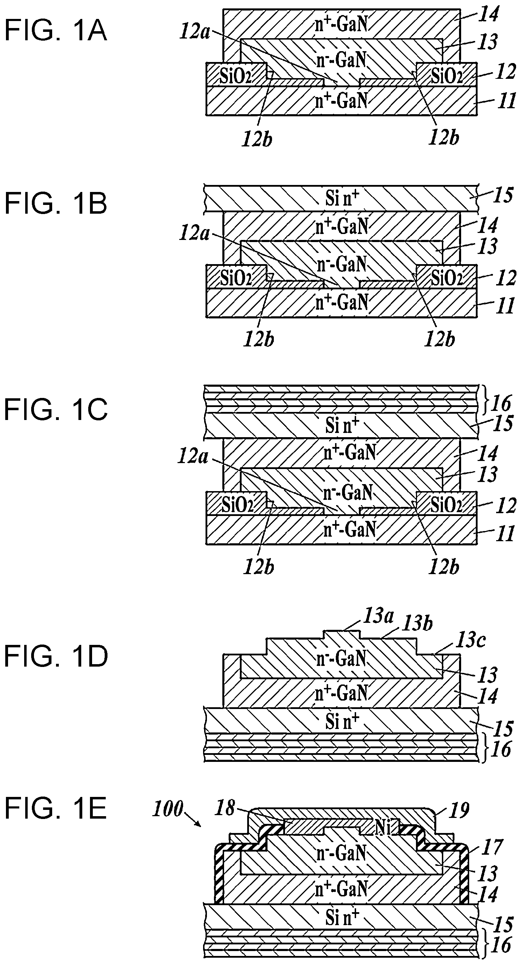

A mask 12 made of Si02 is formed on the upper surface of a GaN layer which is a surface layer of a substrate 11 illustrated in Fig. 1A. The lower surface of the GaN layer which is the surface layer of the substrate 11 may be supported by a component, such as a silicon substrate (not illustrated), other than GaN. The component may be, for example, a sapphire substrate or a SiC (silicon carbide) substrate. Another material such as SiN, AlN, Al2O3, or Ga2O3 may be used as the material of the mask 12. The mask 12 may be amorphous.

The mask 12 has an opening 12a. In this embodiment, a peripheral upper surface region of the opening 12a is subjected to a region selection due to a shape. The region selection is due to a shape having a difference in level 12b and is a selection for dividing a region into an upper side and a lower side of the difference in level. The difference in level 12b surrounds the entire periphery of the opening 12a, and a lower step is formed near the opening 12a and an upper step is formed in a region away from the opening 12a. That is, the boundary line between the regions divided by the region selection surrounds the opening 12a. Such a shape with the difference in level 12b is formed by, for example, a well-known photolithography technique and wet etching or dry etching.

Next, GaN is epitaxially grown from the surface of the substrate 11 exposed from the opening 12a to the top of the peripheral upper surface region by the ELO technique described above to form a GaN layer 13. In this case, since the GaN layer 13 is grown to the top of the peripheral upper surface region that has been subjected to the region selection, the GaN layer 13 extends to different regions that have been subjected to the region selection. In this embodiment, the different regions that have been subjected to the region selection are the lower step and the upper step with respect to the difference in level 12b. Accordingly, the GaN layer 13 extends not only to the lower step but also to the upper step.

As a result, a stepped shape is transferred to the lower surface of the GaN layer 13. Thus, the effect of the region selection in this embodiment is the transfer of the shape to a semiconductor layer.

The doping amount of an n-type impurity is controlled such that the GaN layer 13 has an electron carrier concentration of less than 10¹⁷ cm⁻³. The n-type impurity may be, for example, Si (silicon). This enables the formation of a voltage withstanding layer in which a depletion layer spreads when a voltage is applied during the operation of the device.

Furthermore, in this embodiment, in order to obtain a desired impurity concentration profile, a GaN layer 14 having a high impurity concentration is epitaxially grown so as to cover the GaN layer 13, thereby forming the state illustrated in Fig. 1A.

As described above, a semiconductor element having a semiconductor layer (GaN layer 13) in which the effect of the region selection on the upper surface of the mask 12 remains is fabricated.

Next, as illustrated in Fig. 1B, a surface of a semiconductor layer (upper surface of the GaN layer 14) opposite to the substrate 11 is joined to a support substrate 15. A joining via a metal or a direct joining may be used as the joining to reduce the resistance of the connection.

Next, as illustrated in Fig. 1C, a back-surface electrode 16 is formed on the upper surface of the support substrate 15 by, for example, sputtering. The back-surface electrode 16 is, for example, an Al layer plated with Ti, Ni, and Au.

The back-surface electrode may be formed after an upper-surface-electrode metal film 19 described later is formed. Alternatively, a support substrate 15 on which a back-surface electrode 16 is provided in advance may be used. The support substrate 15 may be formed of a semiconductor having a high impurity concentration so as to achieve a low resistance.

Next, the semiconductor layers 13 and 14 are separated from the substrate 11 in the state where the surface of the semiconductor layer (upper surface of the GaN layer 14) is joined to the support substrate 15. The mask 12 is previously dissolved by wet etching, dry etching, or the like, and cracks are then formed in crystals near the opening 12a by, for example, ultrasonic waves to perform stripping from the substrate 11.

After the separation, the resulting product is turned upside down to form the state illustrated in Fig. 1D.

As illustrated in Fig. 1D, with respect to a surface 13a of the semiconductor layer 13 separated from the substrate 11, a step 13b is formed around the surface 13a at a position one step lower from the surface 13a, and a step 13c is formed around the step 13b at a position one step lower from the step 13b. A difference in level 13b-13c is used as a mesa structure.

Next, an insulating film 17 that has an opening surrounding the surface 13a and that covers the mesa structure (13b-13c) is formed. Next, a Schottky metal film 18 that is joined to the GaN layer 13 exposed in the opening of the insulating film 17 by Schottky junction is formed. The opening of the insulating film 17 is covered with the Schottky metal film 18.

Next, an upper-surface-electrode metal film 19 extending to the mesa structure (13b-13c) is formed on the Schottky metal film 18 and on the insulating film 17. The upper-surface-electrode metal film 19 forms the so-called field plate on the insulating film 17.

Thus, a semiconductor element 100 is manufactured. Here, the semiconductor element 100 is a Schottky barrier diode.

As described above, the mesa structure is formed in the semiconductor element 100 by transferring the shape of the mask 12.

The shape is not limited to the embodiment described above and may have a difference in level at two or more positions. In Fig. 1A, not only a difference in level ascending from the opening 12a toward the periphery but also a difference in level descending downward can be carried out. Accordingly, a protruding shape can also be formed by forming a shape that ascends upward once and descends downward. A trench structure can also be formed by transferring such a protruding shape of the mask 12. Accordingly, the mesa structure may be a trench structure. Alternatively, one or a plurality of trench structures and a mesa structure at the outermost edge can be formed from the center of the semiconductor element 100 toward the periphery thereof.

The shape may be a step with an inclination or a structure with a rounded corner.

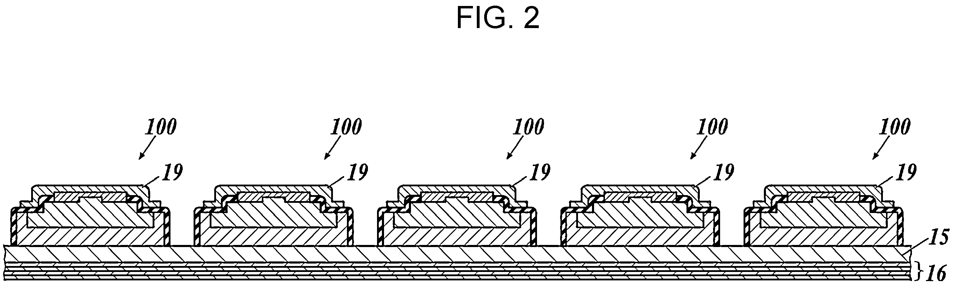

The manufacturing process described above is simultaneously performed in parallel so as to manufacture a plurality of semiconductor elements 100 at the same time, as illustrated in Fig. 2. Specifically, a plurality of openings 12a is formed in the mask 12, and a plurality of semiconductor elements is fabricated at the same time so that one semiconductor element corresponds to one opening.

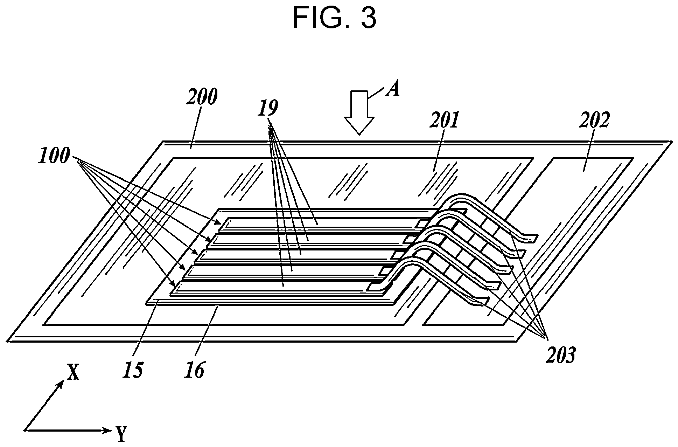

The semiconductor elements 100 can be separated into pieces and individually used as a semiconductor device. However, if it is necessary to increase the capacity, while the support substrate 15 and the back-surface electrode 16 are shared by the plurality of semiconductor elements 100 as illustrated in Fig. 2, the semiconductor elements 100 can be mounted and used as a semiconductor device, as illustrated in Fig. 3.

As illustrated in Fig. 3, the common back-surface electrode 16 is die-bonded to one electrode pad 201 on a mounting substrate 200, and upper-surface-electrode metal films 19 are each connected to another electrode pad 202 through bonding wires 203.

Mounting in this manner enables a plurality of diodes to be connected in parallel and to be used in a large capacity. In this case, the manufacturing is performed such that the plurality of semiconductor elements 100 is arranged side by side in one direction X. The semiconductor elements 100 each have, in plan view (as viewed in the direction of arrow A), a shape that is long in a direction Y substantially orthogonal to the direction X in which the semiconductor elements 100 are arranged. Such a shape and an arrangement easily increase the junction area of the diodes.

For this purpose, the opening 12a of the mask 12 in the manufacturing process has a substantially rectangular shape in plan view perpendicular to the substrate 11. The long-side direction of this rectangle is a direction perpendicular to the drawing in Fig. 2. As a result of epitaxial growth from the substantially rectangular opening 12a, the semiconductor layers 13 and 14 and the semiconductor element 100 that mainly includes the semiconductor layers 13 and 14 each have a substantially rectangular shape having a long-side direction (Y) in the long-side direction of the opening 12a of the mask 12 in plan view.

### [Second Embodiment]

Next, a second embodiment which is another embodiment will be described.

In this embodiment, a region selection on a mask 12 is due to a predetermined element that is selectively arranged, and the effect of the region selection on a semiconductor layer is diffusion of the element into the semiconductor layer.

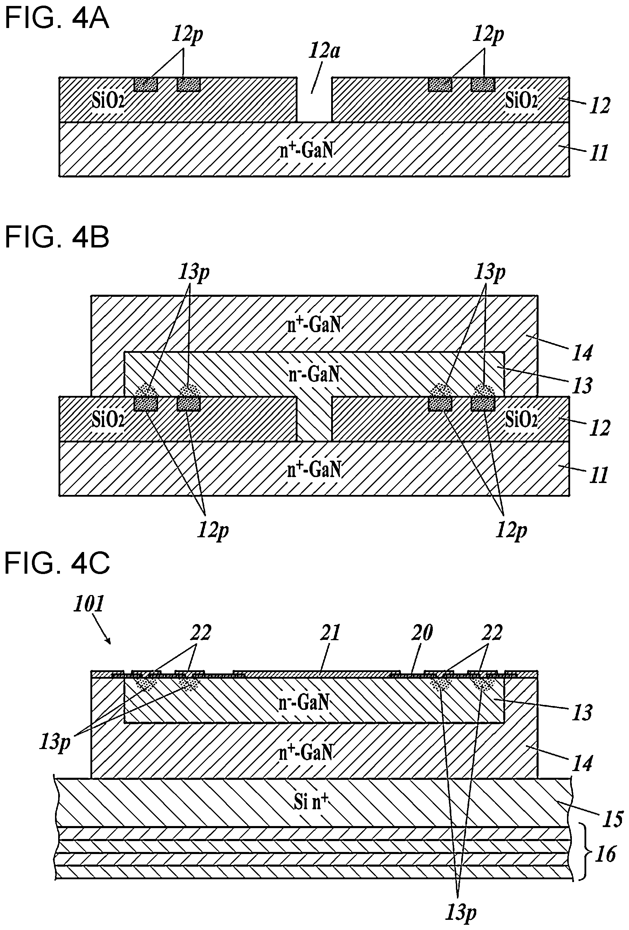

As illustrated in Fig. 4A, an element is arranged for a mask 12 instead of the difference in level of the first embodiment. Here, a P-type impurity 12p is arranged. The method for arranging the P-type impurity 12p is not particularly limited and may be a method in which the P-type impurity 12p is introduced into the mask 12, as illustrated in Fig. 4A. Sputtering, thermal diffusion, or the like can be used for the introduction method. This gives a region selection, that is, a region selection for division into regions in which the P-type impurity 12p is arranged and other regions.

Alternatively, a compound including a P-type impurity (a compound including a substance to be diffused into a semiconductor layer 13) may be arranged for the mask 12. Regarding the arrangement position, the region may be previously formed in such a manner that the compound is arranged to be embedded so as not to affect the outer shape of the mask 12, or the compound may be arranged on the mask 12. If a shape having a difference in level on the upper surface of the mask 12 is formed, a region selection due to the shape and a region selection due to the substance are given at the same time. That is, a mask 12 that has been subjected to region selections due to the shape and the substance is provided. The P-type impurity 12p is arranged in a ring shape surrounding an opening 12a.

After the mask 12 is subjected to the region selection due to an element, GaN layers 13 and 14 are formed by epitaxial growth as in the first embodiment (Fig. 4B).

Consequently, part of the P-type impurity 12p moves into the GaN layer 13 and diffuses into the GaN layer 13 to form P-type regions 13p in the GaN layer 13. In this case, the diffusion of the P-type impurity 12p may be naturally performed in a high-temperature state during epitaxial growth of the GaN layers 13 and 14, or a heating step of diffusing the P-type impurity 12p may be further separately provided.

The joining of a support substrate 15 and the formation of a back-surface electrode 16 are also similarly performed, and an insulating film 20 having openings is then formed on the surface of the GaN layer 13, as illustrated in Fig. 4C. Furthermore, through the openings of the insulating film 20, a Schottky metal film 21 that is joined to the N-type region of the GaN layer 13 by Schottky junction and metal rings 22 that are joined to the P-type regions 13p by ohmic junction are formed so that the metal rings 22 function as guard rings.

Thus, a Schottky barrier diode 101 with guard rings can be manufactured. Details described with reference to Figs. 2 and 3 can be similarly carried out.

### [Third Embodiment]

A third embodiment which is still another embodiment will be described.

In this embodiment, the second embodiment is partially changed, and a semiconductor element 102 in which a PN junction and a Schottky junction coexist is manufactured.

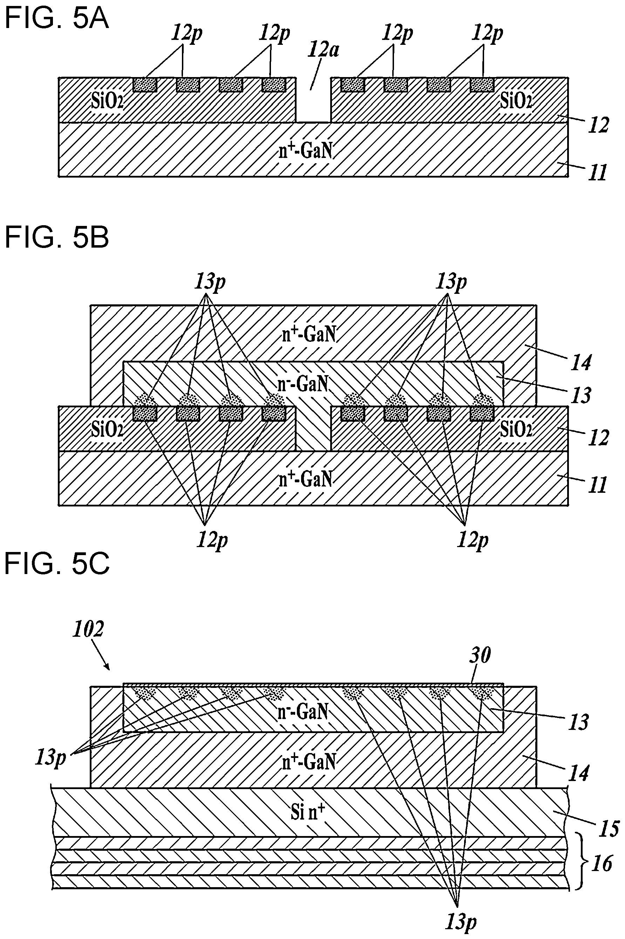

As illustrated in Figs. 5A and 5B, a manufacturing process similar to that of the second embodiment is performed. The number of lines of the P-type impurity 12p and the arrangement thereof are freely selected.

As illustrated in Fig. 5C, the separation from a substrate 11 and a mask 12 and the formation of a back-surface electrode 16 are completed, and an upper-surface-electrode metal film 30 is formed on the surface of a GaN layer 13.

The upper-surface-electrode metal film 30 is joined to P-type regions 13p and N-type regions of the GaN layer 13. Specifically, the upper-surface-electrode metal film 30 that is joined to the P-type regions 13p by ohmic junction and is joined to the N-type regions adjacent to the P-type regions 13p by Schottky junction is formed.

Thus, the semiconductor element 102 in which a PN junction and a Schottky junction coexist can be manufactured. Details described with reference to Figs. 2 and 3 can be similarly carried out.

According to the above embodiments of the present disclosure, a structure due to the effect of a region selection on the mask 12 can be formed on a surface of the semiconductor layers 13 and 14 that are epitaxially grown on the mask 12, the surface being in contact with the upper surface of the mask 12. Furthermore, by separating the semiconductor layers 13 and 14 from the substrate 11 and placing the resulting element such that the structure is located on the upper surface side of the element, a base of a high withstand voltage structure such as a mesa step, a field plate, or a guard ring can be provided.

Although embodiments of the present disclosure have been described above, these embodiments are presented as examples and can be carried out in other various forms, and omissions, replacements, and changes are possible within the range that does not depart from the gist of the invention.

For example, various structures other than the structures presented as examples may be formed by appropriately combining the first embodiment, the second embodiment, and the third embodiment.

For example, in the second embodiment and the third embodiment, an N-type impurity may be diffused into the GaN layer instead of the P-type impurity.

In the embodiments described above, a region selection due to the shape and a region selection due to the arrangement of a substance have been described. However, the region selection on the mask is not limited as long as the mask is physically or chemically subjected to a region selection due to a macroscopic or microscopic change in the structure, and the region selection leaves, so as to correspond to regions divided by the selection (sorting), different effects on epitaxial films that are grown on the regions.

The region selection due to the shape can be achieved by a change in the inclination or a change in the surface roughness, and the shape is transferred. Even in the case of the same substance, a region selection may be achieved by a difference in the crystal structure or crystal orientation.

### Industrial Applicability

The present disclosure is applicable to a method for manufacturing a semiconductor element, and a semiconductor device.

### Reference Signs List

- 11: substrate
- 12: mask
- 12a: opening of mask
- 12b: difference in level
- 12p: P-type impurity
- 13: GaN layer (semiconductor layer)
- 13p: P-type region
- 14: GaN layer (semiconductor layer)
- 15: support substrate
- 16: back-surface electrode
- 17: insulating film
- 18: Schottky metal film
- 19: upper-surface-electrode metal film
- 20: insulating film
- 21: Schottky metal film
- 22: metal ring (guard ring)
- 30: upper-surface-electrode metal film
- 100: semiconductor element (diode)
- 200: mounting substrate
- 201: electrode pad
- 202: electrode pad
- 203: bonding wire

## Claims

1. A method for manufacturing a semiconductor element, comprising:
providing, on a surface of a substrate, a mask which has an opening and in which a peripheral upper surface region of the opening is processed to have a predetermined structure; and
epitaxially growing a semiconductor from the surface of the substrate exposed from the opening to the top of the peripheral upper surface region to fabricate a semiconductor element having a semiconductor layer with the predetermined structure transferred thereon.

2. The method for manufacturing a semiconductor element according to claim 1, wherein the predetermined structure is a shape having a difference in level.

3. The method for manufacturing a semiconductor element according to claim 2, wherein a mesa structure or a trench structure is formed in the semiconductor element by transferring the shape.

4. The method for manufacturing a semiconductor element according to any one of claims 1 to 3, wherein the processed region surrounds the opening.

5. The method for manufacturing a semiconductor element according to claim 3, comprising:
removing the mask;
separating the semiconductor layer from the substrate in a state where a surface of the semiconductor layer opposite to the substrate is joined to a support substrate;
subsequently forming an insulating film that has an opening surrounding a surface of the semiconductor layer separated from the substrate and that covers the mesa structure or the trench structure; and
subsequently covering the opening of the insulating film and forming, on the insulating film, a metal film extending to the mesa structure or the trench structure.

6. The method for manufacturing a semiconductor element according to claim 1,
wherein the predetermined structure is formed by selectively arranging a predetermined element for the mask, and
the element is moved into the semiconductor layer by the transfer.

7. The method for manufacturing a semiconductor element according to claim 1 or 6, wherein the predetermined element is arranged for the mask by introducing the predetermined element into the mask.

8. The method for manufacturing a semiconductor element according to claim 1 or 6, wherein the predetermined element is arranged for the mask by arranging a compound including the predetermined element.

9. The method for manufacturing a semiconductor element according to claim 6 or 7, wherein the processed region surrounds the opening.

10. The method for manufacturing a semiconductor element according to claim 9, comprising:
epitaxially growing the semiconductor to be of N-type;
diffusing a P-type impurity as the element into the semiconductor layer to form a P-type region in the semiconductor layer;
subsequently removing the mask;
separating the semiconductor layer from the substrate in a state where a surface of the semiconductor layer opposite to the substrate is joined to a support substrate; and
subsequently forming a metal ring joined to the P-type region to function as a guard ring.

11. The method for manufacturing a semiconductor element according to claim 9, comprising:
epitaxially growing the semiconductor to be of N-type;
diffusing a P-type impurity as the substance into the semiconductor layer to form a P-type region in the semiconductor layer;
subsequently removing the mask;
separating the semiconductor layer from the substrate in a state where a surface of the semiconductor layer opposite to the substrate is joined to a support substrate; and
subsequently forming a metal film that is joined to the P-type region by ohmic junction and that is joined to the N-type region adjacent to the P-type region by Schottky junction.

12. The method for manufacturing a semiconductor element according to any one of claims 1 to 11,
wherein the opening of the mask has a substantially rectangular shape in plan view, and
the semiconductor layer has a substantially rectangular shape having a long-side direction in a long-side direction of the opening of the mask in plan view.

13. The method for manufacturing a semiconductor element according to any one of claims 1 to 12, wherein a plurality of openings is formed in the mask, and a plurality of semiconductor elements is fabricated at the same time so that one semiconductor element corresponds to one opening.

14. A semiconductor device comprising a semiconductor element manufactured by the method for manufacturing a semiconductor element according to any one of claims 1 to 13.
